# EUROPEAN PATENT APPLICATION

(11) **EP 4 534 449 A1**
(43) Date of publication of application: **09.04.2025**
(21) Application number: 23815624.4
(22) Date of filing: 24.04.2023
(51) Int. Cl.: B65G 1/00, B65G 1/04, H01L 21/677

(54) **OVERHEAD TRANSPORT VEHICLE**

(30) Priority: 01.06.2022 JP 2022089789
(71) Applicant: Murata Machinery, Ltd., Kyoto-shi, Kyoto 601-8326 (JP)
(72) Inventor: WADA, Eiji, Inuyama-shi, Aichi 484-8502 (JP)
(74) Representative: Weickmann & Weickmann PartmbB
(86) International application number: PCT/JP2023/016104
(87) International publication number: WO 2023/233863

(57) **Abstract**

[Problem] To suppress application of offset loads in a lateral extender even in a state where a slider is not extended laterally, while ensuring a long lateral extension amount of the slider.

[Means to Solve Problem] An overhead transport vehicle 1 includes: a base 10 provided on a main body 4; a slider 20 provided with a transfer device 8 and arranged on a lower face side of the base 10; a first linear guide 40 that is provided between the base 10 and the slider 20, is movable in a lateral direction D relative to the base 10 and the slider 20, and supports the slider 20 so as to allow it to extend laterally relative to the base 10; and a first transmission 50 that regulates a position of the first linear guide 40 when the slider 20 is not moving in the lateral extension direction relative to the base 10, and that moves the first linear guide 40 in the lateral extension direction when the slider 20 is moving in the lateral extension direction relative to the base 10.

## Description

### Technical Field

The present invention relates to an overhead transport vehicle.

### Background Art

An overhead transport vehicle is known that includes a main body that travels along an overhead track and a lateral extender that laterally extends a transfer device for articles in the left-right direction relative to the traveling direction of the main body (see Patent Literature 1). This lateral extender includes a base provided on the main body, a slider on which the transfer device is provided, and which is arranged on the lower face side of the base, and a linear guide provided between the base and the slide. The linear guide is movable in the direction of lateral extension relative to the base and the slider and supports the slider so as to allow it to laterally extend relative to the base.

### Citation List

### Patent Literature

[Patent Literature 1] Japanese Patent No. 4277287

### Summary of Invention

### Technical Problem

The linear guide disclosed in Patent Literature 1 is movable in the direction of lateral extension relative to the base and the slider. Therefore, when the slider is not extended laterally, the linear guide may move to a position significantly offset in the lateral extension direction from the center of the base. In such a case, the offset load is kept applied in the lateral extender, and particularly when the transfer device is holding an article, the additional weight of the article may hinder the traveling of the overhead traveling vehicle. On the other hand, fixing the linear guide at the center of the base reduces the movable range of the slider, leading to a reduced lateral extension, which is not desirable.

An object of the present invention is to provide an overhead transport vehicle capable of suppressing application of offset loads in a lateral extender even in a state where a slider is not extended laterally, while ensuring a long lateral extension amount of the slider.

### Means for Solving Problem

An overhead transport vehicle according to an aspect of the present invention includes: a main body that travels along an overhead track; and a lateral extender that laterally extends a transfer device for an article in a left-right direction relative to a traveling direction of the main body. The lateral extender includes a base provided on the main body, a slider provided with the transfer device and arranged on a lower face side of the base, a first linear guide that is provided between the base and the slider, is movable in a lateral direction relative to the base and the slider, and supports the slider so as to allow it to extend laterally relative to the base, and a first transmission that regulates a position of the first linear guide when the slider is not moving in the lateral extension direction relative to the base, and that moves the first linear guide in the lateral extension direction when the slider is moving in the lateral extension direction relative to the base.

### Advantageous Effects of the Invention

According to the overhead transport vehicle according to the above aspect, the first transmission regulates the position of the first linear guide relative to the base when the slider is extended laterally relative to the base, and moves the first linear guide in the same direction as the slider, with a movement amount smaller than the lateral extension amount of the slider, in accordance with the lateral extension amount of the slider in the lateral extension direction. Thus, the first linear guide is prevented from being offset, and application of offset loads in the lateral extender is suppressed, even in a state where the slider is not extended laterally relative to the base, while ensuring a long lateral extension amount of the slider relative to the base. As a result, it is possible to enable stable traveling of the overhead transport vehicle.

In the overhead transport vehicle of the above aspect, the first transmission may regulate the first linear guide to the center or approximately the center of the base in the lateral extension direction in the initial state where the slider is not extended laterally. With this configuration, it is possible to position the first linear guide at the center or approximately the center of the base, enabling a balanced load to be applied to the lateral extender.

In the overhead transport vehicle of the above aspect, when laterally extending the slider from the initial state, the first transmission may move the first linear guide in the same direction as the direction in which the slider is extended laterally, with a movement amount equal to half of the lateral extension amount of the slider. With this configuration, it is possible to regulate the position of the first linear guide, while ensuring a long lateral extension amount of the slider.

In the overhead transport vehicle of the above aspect, the first transmission may include a right-side wrapping transmission member, one end of which is fixed to a first right-side fixture provided on a right side of the base in the lateral extension direction and wrapped around a left-side guide member provided on a left side of the first linear guide in the lateral extension direction, while another end of which is fixed to a second right-side fixture provided on a right side of the slider in the lateral extension direction, and a left-side wrapping transmission member, one end of which is fixed to a first left-side fixture provided on a left side of the base in the lateral extension direction and wrapped around a right-side guide member provided on a right side of the first linear guide in the lateral extension direction, while another end of which is fixed to a second left-side fixture provided on a left side of the slider in the lateral extension direction. With this configuration, it is easily possible to move the first linear guide in the same direction as the slider, with a movement amount smaller than the lateral extension amount of the slider, in accordance with the lateral extension amount of the slider in the lateral extension direction.

In the overhead transport vehicle of the above aspect, the first right-side wrapping transmission member and the first left-side wrapping transmission member may be set to have a same or approximately same length. With this configuration, it is possible in the initial state to position the first linear guide at the center or approximately the center of the base.

In the overhead transport vehicle of the above aspect, the slider may include a first slider arranged on the lower face side of the base, and a second slider provided with the transfer device and arranged on the lower face side of the first slider, and there may be included a second linear guide that is provided between the first slider and the second slider, is movable in a lateral direction relative to the first slider and the second slider, and supports the second slider so as to allow it to extend laterally relative to the first slider, and a second transmission that regulates a position of the second linear guide when the second slider is not moving in the lateral extension direction relative to the first slider, and that moves the second linear guide in the lateral extension direction when the second slider is moving in the lateral extension direction relative to the first slider. With this configuration, in the case where the lateral extender is of a three-stage configuration consisting of the base, the first slider, and the second slider, the first linear guide and the second linear guide can be prevented from being offset, and application of offset loads in the lateral extender is suppressed, even in a state where the first slider and the second slider are not extended laterally relative to the base, while ensuring a long lateral extension amount of both the first slider and the second slider relative to the base.

In the overhead transport vehicle of the above aspect, the first transmission may regulate the first linear guide to the center or approximately the center of the base in the lateral extension direction in an initial state in which the first slider and the second slider are not extended laterally, and the second transmission may regulate the second linear guide to the center or approximately the center of the first slider in the lateral extension direction in the initial state. With this configuration, in the case where the lateral extender is of a three-stage configuration, it is possible to position the first linear guide and the second linear guide at the center or approximately the center, enabling a balanced load to be applied to the lateral extender.

In the overhead transport vehicle of the above aspect, when laterally extending the first slider from the initial state, the first transmission may move the first linear guide in the same direction as a direction in which the first slider is extended laterally, with a movement amount equal to half of a lateral extension amount of the first slider, and when laterally extending the second slider from the initial state, the second transmission may move the second linear guide in the same direction as a direction in which the second slider is extended laterally, with a movement amount equal to half of a lateral extension amount of the second slider. With this configuration, it is possible to regulate the position of the first linear guide while ensuring a long lateral extension amount of the first slider and regulate the position of the second linear guide while ensuring a long lateral extension amount of the second slider.

In the overhead transport vehicle of the above aspect, the first transmission may include a first right-side wrapping transmission member, one end of which is fixed to a first right-side fixture provided on a right side of the base in the lateral extension direction and wrapped around a first left-side guide member provided on a left side of the first linear guide in the lateral extension direction, while another end of which is fixed to a second right-side fixture provided on a right side of the first slider in the lateral extension direction, and a first left-side wrapping transmission member, one end of which is fixed to a first left-side fixture provided on a left side of the base in the lateral extension direction and wrapped around a first right-side guide member provided on a right side of the first linear guide in the lateral extension direction, while another end of which is fixed to a second left-side fixture provided on a left side of the first slider in the lateral extension direction, and the second transmission may include a second right-side wrapping transmission member, one end of which is fixed to a third right-side fixture provided on a right side of the first slider in the lateral extension direction and wrapped around a second left-side guide member provided on a left side of the second linear guide in the lateral extension direction, while another end of which is fixed to a fourth right-side fixture provided on a right side of the second slider in the lateral extension direction, and a second left-side wrapping transmission member, one end of which is fixed to a third left-side fixture provided on a left side of the first slider in the lateral extension direction and wrapped around a second right-side guide member provided on a right side of the second linear guide in the lateral extension direction, while another end of which is fixed to a fourth left-side fixture provided on a left side of the second slider in the lateral extension direction. With this configuration, it is easily possible to move the first linear guide in the same direction as the first slider, with a movement amount smaller than the lateral extension amount of the first slider, in accordance with the lateral extension amount of the first slider in the lateral extension direction, and it is easily possible to move the second linear guide in the same direction as the second slider, with a movement amount smaller than the lateral extension amount of the second slider, in accordance with the lateral extension amount of the second slider in the lateral extension direction.

In the overhead transport vehicle of the above aspect, the first right-side wrapping transmission member and the first left-side wrapping transmission member may be set to have a same or approximately same length, and the second right-side wrapping transmission member and the second left-side wrapping transmission member may be set to have a same or approximately same length. With this configuration, it is possible in the initial state to position both the first linear guide and the second linear guide at the center or approximately the center of the base.

### Brief Description of the Drawings

Fig. 1 is a diagram conceptually showing an overhead transport vehicle according to a first embodiment.
Fig. 2 is a diagram of a lateral extender of the overhead transport vehicle according to the first embodiment, as viewed from the X direction.
Fig. 3 is a diagram of the lateral extender of the overhead transport vehicle according to the first embodiment, as viewed from the Z direction.
Fig. 4 is a diagram for describing a lateral extension operation in the +Y direction performed by the lateral extender of the overhead transport vehicle according to the first embodiment.
Fig. 5 is a diagram for describing the lateral extension operation in the +Y direction performed by the lateral extender of the overhead transport vehicle according to the first embodiment.
Fig. 6 is a diagram for describing a lateral extension operation in the -Y direction performed by the lateral extender of the overhead transport vehicle according to the first embodiment.
Fig. 7 is a diagram for describing the lateral extension operation in the -Y direction performed by the lateral extender of the overhead transport vehicle according to the first embodiment.
Fig. 8 is a diagram of a lateral extender of an overhead transport vehicle according to the second embodiment, as viewed from the X direction.
Fig. 9 is a diagram of the lateral extender of the overhead transport vehicle according to the second embodiment, as viewed from the Z direction.
Fig. 10 is a diagram for describing a lateral extension operation in the +Y direction performed by the lateral extender of the overhead transport vehicle according to the second embodiment.
Fig. 11 is a diagram for describing a lateral extension operation in the +Y direction performed by the lateral extender of the overhead transport vehicle according to the second embodiment.
Fig. 12 is a diagram for describing a lateral extension operation in the -Y direction performed by the lateral extender of the overhead transport vehicle according to the second embodiment.
Fig. 13 is a diagram for describing the lateral extension operation in the -Y direction performed by the lateral extender of the overhead transport vehicle according to the second embodiment.
Fig. 14 is a diagram of a first transmission according to a modified example, as viewed from the X direction.
Fig. 15 is a diagram of the first transmission according to the modified example, as viewed from the Z direction.
Fig. 16 is a diagram showing a state where a slider is extended laterally.

### Description of Embodiments

Hereinafter, the present invention will be described through embodiments. However, the following embodiments do not limit the invention according to the claims, and not all combinations of features described in the embodiments are essential to the means by which the present invention solves the above problems. In the drawings, the same or similar members are denoted by the same reference signs, and redundant descriptions may be omitted or simplified. The shapes and sizes of elements in the drawings may be exaggerated for clarity, and the dimensions and shapes may differ from the actual product. In the drawings, an XYZ coordinate system is used to describe directions in each drawing. In the XYZ coordinate system, a plane that is parallel to a horizontal plane is defined as an XY plane. In this XY plane, the traveling direction of an overhead transport vehicle 1 is denoted as X direction, and a left-right direction orthogonal to the X direction is denoted as Y direction. A direction perpendicular to the XY plane is denoted as Z direction. For each of the X direction, the Y direction, and the Z direction, description is made with a definition in which a direction indicated by an arrow is the positive (+) direction and a direction opposite to the direction indicated by the arrow is the negative (-) direction.

### First Embodiment

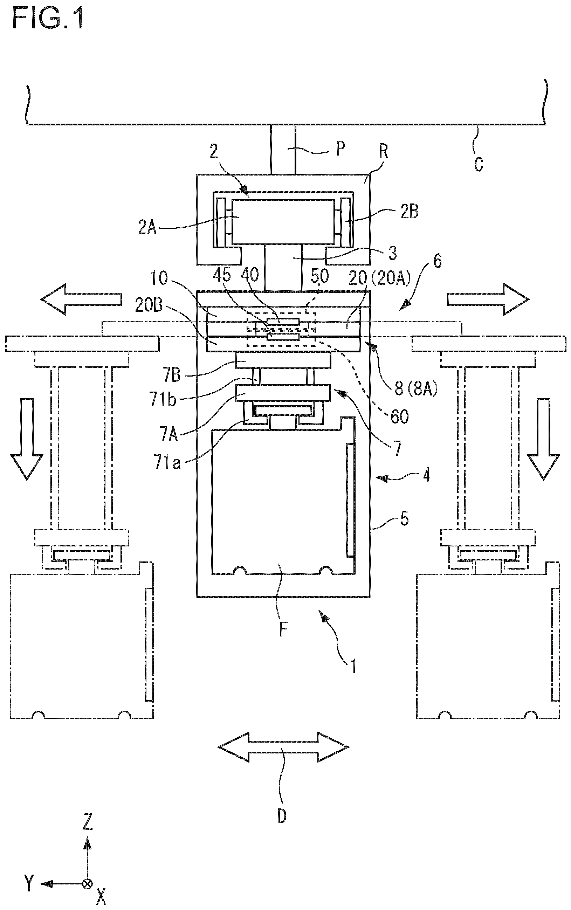

Fig. 1 is a diagram conceptually showing an overhead transport vehicle according to a first embodiment. Fig. 1 conceptually shows an overhead transport vehicle 1 according to the first embodiment as viewed from the +X side. The overhead transport vehicle 1 is used to transport articles F, for example, between a processing apparatus and a container storage apparatus, or between two processing apparatuses. These processing apparatuses are, for example, a film forming device, a coater/developer, an exposure device, or an etching device, and perform various processes during the manufacturing of devices (for example, semiconductor devices). The container storage apparatus mentioned above is arranged, for example, on a transport route along which articles F are transported, and is used to temporarily store the articles F. The container storage apparatus mentioned above is arranged, for example, in the vicinity of a ceiling C. The articles F accommodate, for example, wafers or reticles used for manufacturing semiconductor devices. Examples of the article include a FOUP (Front Opening Unified Pod), a SMIF pod, and a reticle pod, the inside of which can be purged.

As shown in Fig. 1, the overhead transport vehicle 1 includes a traveler 2, a coupler 3, and a main body 4. The traveler 2 has a traveling driver 2A and wheels 2B. The traveler 2 travels along an overhead track R by the driving force of the traveling driver 2A. The overhead track R is a preliminarily defined traveling path (rail) for the traveling of the overhead transport vehicle 1 and is arranged in the vicinity of the ceiling C of a clean room, for example. In the example shown in Fig. 1, the overhead track R is suspended and supported by support columns P fixed to the ceiling C.

The traveling driver 2A generates a driving force to cause the overhead transport vehicle 1 to travel. The traveling driver 2A includes, for example, a linear motor or rotary motor, a rotary encoder or linear encoder, and so forth. Each wheel 2B is arranged so as to be in contact with the overhead track **R.** The wheels 2B are driven to rotate by the driving force of the traveling driver **2A.** The traveling driver 2A controls the linear motor or rotary motor on the basis of detection results such as the rotation speed of the wheels 2B detected by the rotary encoder or linear encoder and controls the speed or stopping position of the overhead transport vehicle 1.

The coupler 3 connects the traveler 2 and the main body 4. For example, one end of the coupler 3 is connected to the traveling driver 2A and the other end to the main body 4. In other words, the overhead transport vehicle 1 travels along the overhead track R, with the traveler 2 suspending the main body 4. The main body 4 is connected to the traveler 2 via the coupler 3 and travels along the overhead track R. The main body 4 includes a main body frame 5 and a transferer 6. The main body frame 5 supports the transferer 6. In addition to the main body frame 5 and the transferer 6, the main body 4 may include a controller (not shown in the drawings) to control the operation of the transferer 6.

The transferer 6 includes a transfer device 7 and a lateral extender 8. The transfer device 7 includes a holder 7A and an elevation driver 7B. The holder 7A holds an article F. For example, the holder 7A grasps and holds a flange of an article F from above, to thereby suspend and hold the article F. The holder 7A is, for example, a chuck that includes a plurality of claws 71a and is movable in the horizontal direction. The holder 7A inserts the claws 71a under the flange of the article F, and rises to suspend and hold the article F. The holder 7A is connected to suspenders 71b such as wires or belts. The holder 7A is suspended from the elevation driver 7B via the suspenders 71b and is raised or lowered by the elevation driver 7B.

The elevation driver 7B is controlled, for example, by a controller (not shown in the drawings) provided in the main body 4, and lowers or raises the holder 7A at a predetermined speed and also holds the holder 7A at a target height. The elevation driver 7B is, for example, a hoist. The elevation driver 7B, for example, lowers the holder 7A by feeding out the suspenders 71b and raises the holder 7A by retracting the suspenders 71b.

The lateral extender 8 laterally extends the transfer device 7 in the left-right direction relative to the traveling direction of the main body 4. The traveling direction of the main body 4 is a direction in which the overhead transport vehicle 1 travels along the overhead track R by means of the traveler 2, that is, the X direction. The left-right direction is a direction orthogonal to the traveling direction, that is, the Y direction. The left-right direction is a direction in which the lateral extender 8 laterally extends the transfer device 7, and is hereinafter referred to as lateral extension direction D.

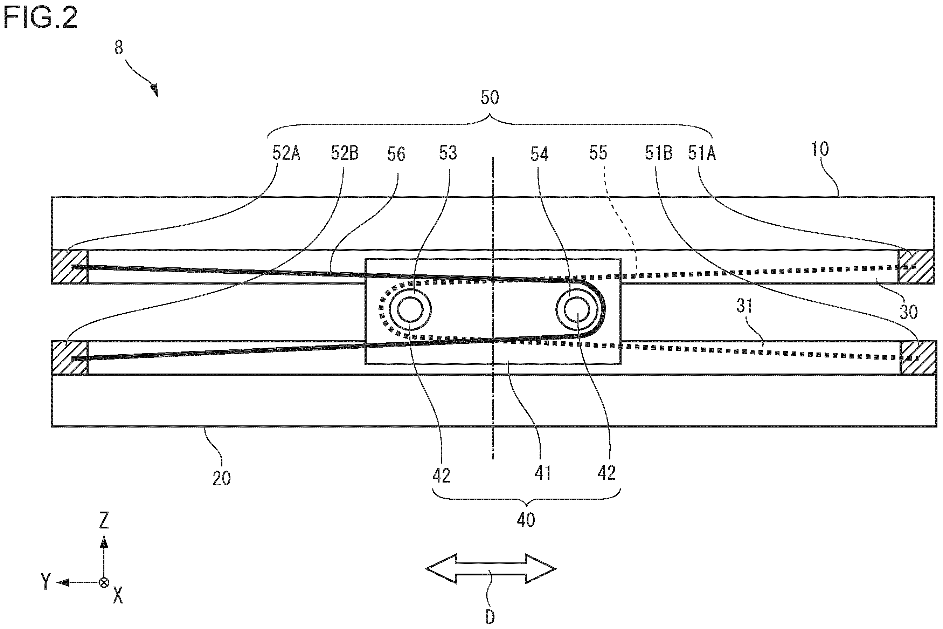

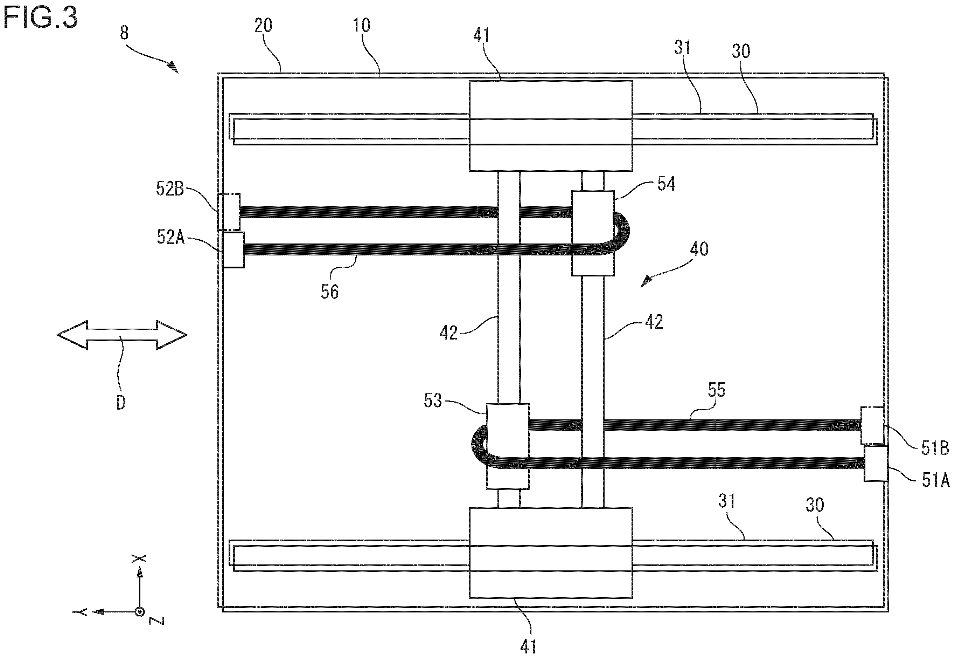

Fig. 2 is a diagram of the lateral extender 8 of the overhead transport vehicle 1 according to the first embodiment, as viewed from the X direction. Fig. 3 is a diagram of the lateral extender 8 of the overhead transport vehicle 1 according to the first embodiment, as viewed from the Z direction. The lateral extender 8 includes a base 10, a slider 20, guide rails 30, 31, a first linear guide 40, and a first transmission 50. The lateral extender 8 (8A) exemplified in Fig. 1 has sliders 20 (20A) and 20B. In the first embodiment, the configuration of the lateral extender 8 is described as having a base 10 and a single slider 20. The reference signs 8A, 20A, 20B, and 60 in Fig. 1 will be described in the second embodiment described later.

The base 10 is provided on the main body 4. For example, the base 10 is attached to a lower part of the coupler 3. The base 10 is, for example, a plate-shaped member. The base 10 is arranged so that the plane of the base 10 is parallel to the horizontal direction. The slider 20 is arranged on the lower face side of the base 10. The slider 20 is, for example, a plate-shaped member, and is arranged so that its plane is parallel to the plane of the base 10 in the Z direction. The slider 20 has the same shape as the base 10. A transfer device 7 is provided on the lower face side of the slider 20. In Fig. 1, the transfer device 7 is provided on the slider 20 via the second slider 20B described in the second embodiment, however, the transfer device 7 may be provided on the lower face of the slider 20.

The guide rail 30 is provided on the lower face of the base 10. For example, each guide rail 30 is provided on the lower face of the base 10, on both sides in the X direction, which is the traveling direction. The guide rail 30 provided on the +X side of the lower face of the base 10 and the guide rail 30 provided on the -X side of the lower face of the base 10 are parallel to each other. Each guide rail 30 is arranged so that its lengthwise direction is parallel to the lateral extension direction D.

The guide rail 31 is provided on the upper face of the slider 20. For example, the guide rail 31 is provided on the upper face of the slider 20, on both sides in the X direction, which is the traveling direction. The guide rail 31 provided on the +X side of the upper face of the slider 20 and the guide rail 31 provided on the -X side of the upper face of the slider 20 are parallel to each other. Each guide rail 31 is arranged so that its lengthwise direction is parallel to the lateral extension direction D. The guide rail 30 on the +X side and the guide rail 31 on the +X side face each other in the Z direction. Also, the guide rail 30 on the -X side and the guide rail 31 on the - X side face each other in the Z direction.

The first linear guide 40 is provided between the base 10 and the slider 20. The first linear guide 40 is movable in the lateral extension direction D relative to the base 10 and the slider 20. The first linear guide 40 supports the slider 20 so as to allow it to extend laterally relative to the base 10. In other words, the first linear guide 40 allows the slider 20 to move in the lateral direction D relative to the base 10. The first linear guide 40 includes two blocks 41 and couplers 42.

The two blocks 41 are each arranged between the guide rail 30 and the guide rail 31. That is to say, the blocks 41 are each arranged between the guide rail 30 on the +X side and the guide rail 31 on the +X side, and between the guide rail 30 on the -X side and the guide rail 31 on the - X side. The blocks 41 are movable in the lateral extension direction D along the guide rails 30, 31 but is provided so as not to deviate in the Z direction. Therefore, the blocks 41 are suspended from the base 10 by the guide rails 30, and the slider 20 is suspended from the blocks 41.

The couplers 42 connect the two blocks 41. Each coupler 42 extends in the X direction, with one end fixed to the block 41 provided on the +X side and the other end fixed to the block 41 provided on the -X side. In the example shown in Fig. 2 and Fig. 3, the two blocks 41 are connected to each other using the two couplers 42. However, the invention is not limited to this configuration, and two blocks 41 may be connected by one coupler 42. Moreover, the shape of the coupler 42 is not particularly limited, and may be a plate shape.

The first transmission 50 regulates the position of the first linear guide 40 in the lateral extension direction D relative to the base 10. Specifically, the first transmission 50 regulates the position of the first linear guide 40 when the slider 20 is not moving in the lateral extension direction D relative to the base 10 and moves the first linear guide 40 in the lateral extension direction D when the slider 20 is moving in the lateral extension direction D relative to the base 10. For example, the first transmission 50 moves the first linear guide 40 in the same direction as the slider 20, with a movement amount smaller than the lateral extension amount of the slider 20, in accordance with the lateral extension amount of the slider 20 in the lateral extension direction D. That is to say, the first linear guide 40 is movable in the lateral extension direction D, however, the movement amount thereof is regulated to an amount according to the lateral extension amount of the slider 20.

The first transmission 50 regulates the first linear guide 40 to the center or approximately the center of the base 10 in the lateral extension direction D in the initial state where the slider 20 is not extended laterally (where the lateral extension amount is zero or approximately zero). When the slider 20 is extended laterally from the initial state, the first transmission 50 moves the first linear guide 40 with a movement amount smaller than the lateral extension amount of the slider 20, relative to the direction in which the slider 20 is extended laterally. When returning the slider 20 to the initial state from the state of being extended laterally, the first transmission 50 returns the first linear guide 40 with a movement amount smaller than the return amount of the slider 20, relative to the return amount of the slider 20.

The first transmission 50 includes a first right-side fixture 51A, a second right-side fixture 51B, a first left-side fixture 52A, a second left-side fixture 52B, a left-side guide member 53, a right-side guide member 54, a right-side wrapping transmission member 55, and a left-side wrapping transmission member 56. The first right-side fixture 51A is provided on the right side of the base 10 in the lateral extension direction D. Here, the right side refers to the -Y side in the lateral extension direction D (Y direction), and the left side refers to the +Y side in the lateral extension direction D (Y direction). The first right-side fixture 51A is fixed to a region to the right side of the center of the base 10 in the lateral extension direction D. As an example, the first right-side fixture 51A is located on the -X side of the center of the base 10 and is fixed to a right-side end of or in the vicinity of the end of the base 10.

The second right-side fixture 51B is provided on the right side of the slider 20 in the lateral extension direction D. The second right-side fixture 51B is fixed to a region to the right side of the center of the slider 20 in the lateral extension direction D. As an example, the second right-side fixture 51B is located on the -X side of the center of the slider 20 and is fixed to a right-side end of or in the vicinity of the end of the slider 20. The second right-side fixture 51B may be fixed at a position facing the first right-side fixture 51A in the Z direction. In other words, the first right-side fixture 51A and the second right-side fixture 51B may be fixed so as to be substantially overlapped when viewed from the Z direction. For the sake of description, in the illustration of Fig. 3, the first right-side fixture 51A and the second right-side fixture 51B are offset from each other in the X direction.

The first left-side fixture 52A is provided on the left side of the base 10 in the lateral extension direction D. The first left-side fixture 52A is fixed to a region to the left side of the center of the base 10 in the lateral extension direction D. As an example, the first left-side fixture 52A is located on the +X side of the center of the base 10 and is fixed to a left-side end of or in the vicinity of the end of the base 10.

The second left-side fixture 52B is provided on the left side of the slider 20 in the lateral extension direction D. The second left-side fixture 52B is fixed to a region to the left side of the center of the slider 20 in the lateral extension direction D. As an example, the second left-side fixture 52B is located on the +X side of the center of the slider 20 and is fixed to a left-side end of or in the vicinity of the end of the slider 20. The second left-side fixture 52B may be fixed at a position facing the first left-side fixture 52A in the Z direction. In other words, the first left-side fixture 52A and the second left-side fixture 52B may be fixed so as to be substantially overlapped when viewed from the Z direction. For the sake of description, in the illustration of Fig. 3, the first left-side fixture 52A and the second left-side fixture 52B are offset from each other in the X direction.

The left-side guide member 53 is provided on the coupler 42. The left-side guide member 53 is provided on the left side in the lateral extension direction D of the first linear guide 40. In the example shown in Fig. 3, the left-side guide member 53 is provided on the left-side coupler 42 of the two couplers 42. The left-side guide member 53 is provided on the -X side of the coupler 42. When viewed from the Z direction, the left-side guide member 53 is arranged on a straight line passing through the first right-side fixture 51A and the second right-side fixture 51B in the Y direction. For example, the face of the left-side guide member 53 that is in contact with the right-side wrapping transmission member 55 is a curved face. The left-side guide member 53 is, for example, a pulley or a roller.

The right-side guide member 54 is provided on the coupler 42. The right-side guide member 54 is provided on the right side in the lateral extension direction D of the first linear guide 40. In the example shown in Fig. 3, the right-side guide member 54 is provided on the right-side coupler 42 of the two couplers 42. The right-side guide member 54 is provided on the +X side of the coupler 42. When viewed from the Z direction, the right-side guide member 54 is arranged on a straight line passing through the first left-side fixture 52A and the second left-side fixture 52B in the Y direction. For example, the face of the right-side guide member 54 that is in contact with the left-side wrapping transmission member 56 is a curved face. The right-side guide member 54 is, for example, a pulley or a roller.

The right-side wrapping transmission member 55 has one end fixed to the first right-side fixture 51A of the base 10. The right-side wrapping transmission member 55 is wrapped around the left-side guide member 53 and has the other end fixed to the second right-side fixture 51B of the slider 20. The right-side wrapping transmission member 55 applies a force to the first linear guide 40, which supports the left-side guide member 53, toward the right side of the lateral extension direction D, that is, in the -Y direction. The right-side wrapping transmission member 55 is, for example, a belt or a wire. The right-side wrapping transmission member 55 may be an elastic member in the form of a belt or string.

The left-side wrapping transmission member 56 has one end fixed to the first left-side fixture 52A of the base 10. The left-side wrapping transmission member 56 is wrapped around the right-side guide member 54 and has the other end fixed to the second left-side fixture 52B of the slider 20. The left-side wrapping transmission member 56 applies a force to the first linear guide 40, which supports the right-side guide member 54, toward the left side of the lateral extension direction D, that is, in the +Y direction. The left-side wrapping transmission member 56 is, for example, a belt or a wire. The left-side wrapping transmission member 56 may be an elastic member in the form of a belt or string. For example, the right-side wrapping transmission member 55 and the left-side wrapping transmission member 56 are set to have a same or approximately same length.

As shown in Fig. 2 and Fig. 3, the first linear guide 40 is regulated from moving in the -Y direction by the left-side wrapping transmission member 56 being wrapped around the right-side guide member 54, and further, the first linear guide 40 is regulated from moving in the +Y direction by the right-side wrapping transmission member 55 being wrapped around the left-side guide member 53. Therefore, in the initial state, the position of the first linear guide 40 is regulated to the center or approximately the center of the base 10 (slider 20) in the Y direction (lateral extension direction D) and the movement of the first linear guide 40 is not unregulated in the Y direction of the base 10 (slider 20). Therefore, the first linear guide 40 is prevented from being arranged offset in the Y direction. As a result, even when the holder 7A is holding an article F, a load is applied to the central portion of the base 10 via the first linear guide 40 from the slider 20. Thus, the main body 4 suspended from the traveler 2 is prevented from tilting, and the overhead transport vehicle 1 can stably travel.

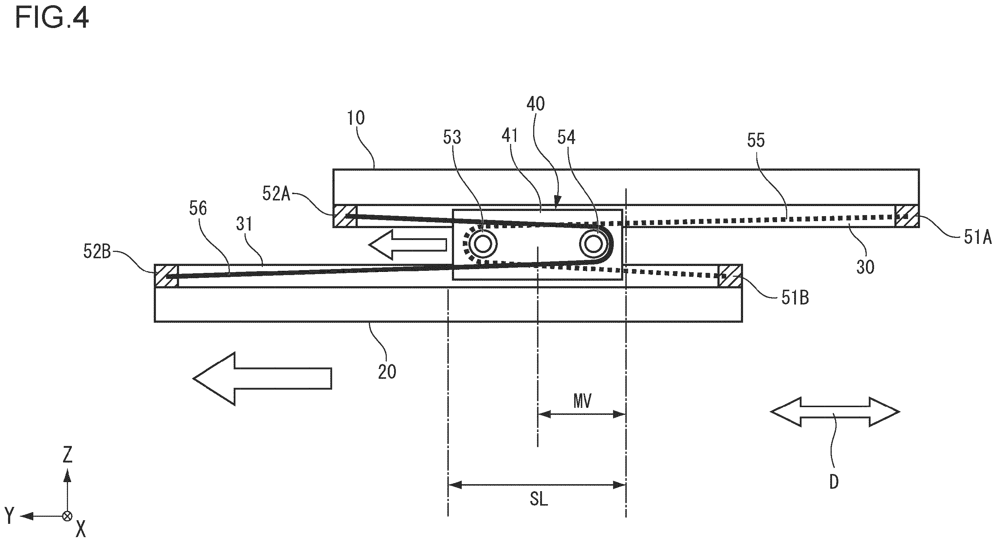

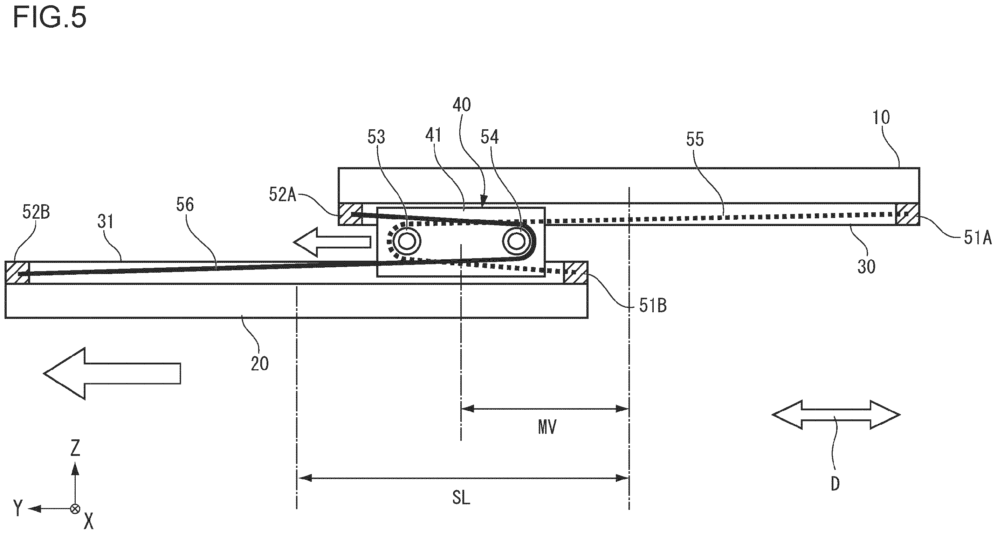

Next, the operation of the lateral extender 8 will be described. A case where the lateral extender 8 laterally extends the slider 20 in the +Y direction will be described, with reference to Fig. 4 and Fig. 5. Fig. 4 and Fig. 5 are both diagrams for describing the lateral extension operation in the +Y direction performed by the lateral extender 8.

By driving a driver not shown in the drawings, the lateral extender 8 laterally extends the slider 20 in the +Y direction from the initial state shown in Fig. 2. As shown in Fig. 4, when the slider 20 is laterally extended in the +Y direction, the end of the left-side wrapping transmission member 56 that is fixed to the second left-side fixture 52B is pulled out in the +Y direction. The left-side wrapping transmission member 56 pushes the right-side guide member 54 in the +Y direction, causing it to move along with the coupler 42 while rotating. As the coupler 42 moves in the +Y direction, the two blocks 41 (first linear guide 40), which are integrated with the coupler 42, move in the +Y direction. At this time, the movement amount of the first linear guide 40 relative to a lateral extension amount SL of the slider 20 in the +Y direction is a movement amount MV that is half of the lateral extension amount SL.

When the slider 20 is extended laterally in the +Y direction, the end of the right-side wrapping transmission member 55 fixed to the second right-side fixture 51B of the slider 20 moves in the +Y direction, however, the end fixed to the first right-side fixture 51A of the base 10 maintains its position. Therefore, the left-side guide member 53 moves in the +Y direction together with the first linear guide 40 while rotating. The first linear guide 40 is regulated from moving in the -Y direction by the left-side wrapping transmission member 56 being wrapped around the right-side guide member 54, and further, the first linear guide 40 is regulated from moving in the +Y direction by the right-side wrapping transmission member 55 being wrapped around the left-side guide member 53.

As shown in Fig. 5, even when the lateral extension amount SL of the slider 20 in the +Y direction reaches its maximum, the first linear guide 40 is still moved by the first transmission 50 in the +Y direction by the movement amount MV, which is half of the lateral extension amount SL. Thus, when the slider 20 is extended laterally in the +Y direction, the first linear guide 40 is moved in the +Y direction by the first transmission 50 by the movement amount MV, which is smaller than (half of) the lateral extension amount SL. The first linear guide 40 is regulated from moving in the Y direction (lateral extension direction D) by the left-side wrapping transmission member 56 being wrapped around the right-side guide member 54 and also the right-side wrapping transmission member 55 being wrapped around the left-side guide member 53. In other words, the first transmission 50 regulates the first linear guide 40 to a predetermined position in the +Y direction, in accordance with the lateral extension amount SL of the slider 20 in the +Y direction.

Thus, the lateral extender 8 laterally extends the slider 20, thereby enabling the holder 7A provided on the lower face side of the slider 20 to be extended laterally in the +Y direction from the main body 4 by the movement amount MV.

When returning the slider 20 from the state of being extended laterally in the +Y direction to the initial state shown in Fig. 2, the first transmission 50 regulates the return amount of the first linear guide 40 (the movement amount MV at the time) in accordance with the return amount of the slider 20 (the lateral extension amount SL at the time). At this time, the return amount of the first linear guide 40 is half of the return amount of the slider 20. As a result, when the slider 20 returns to the initial state shown in Fig. 2, the first linear guide 40 is positioned at the center or approximately the center of the base 10.

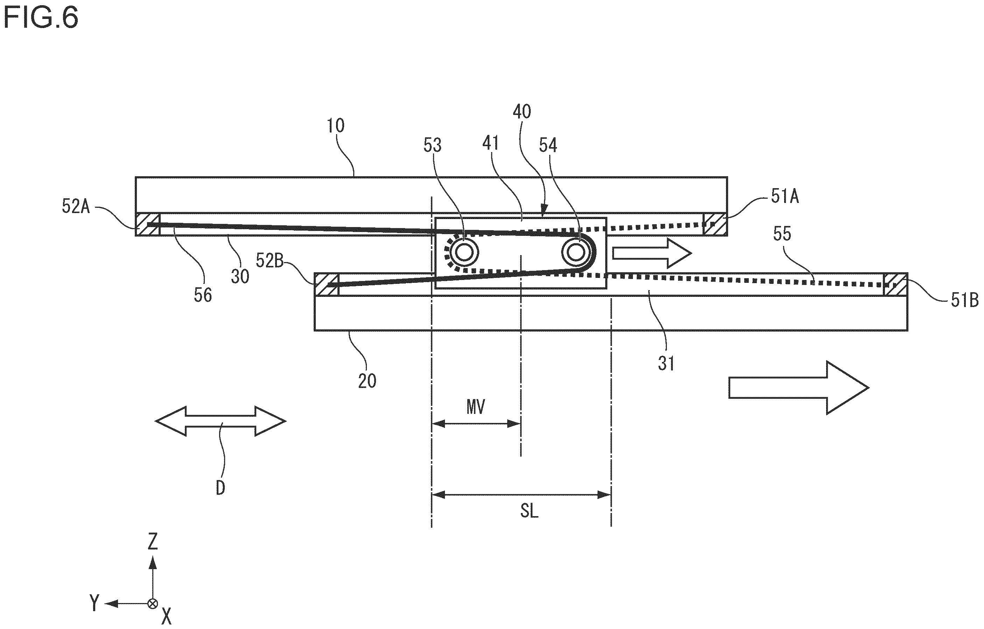

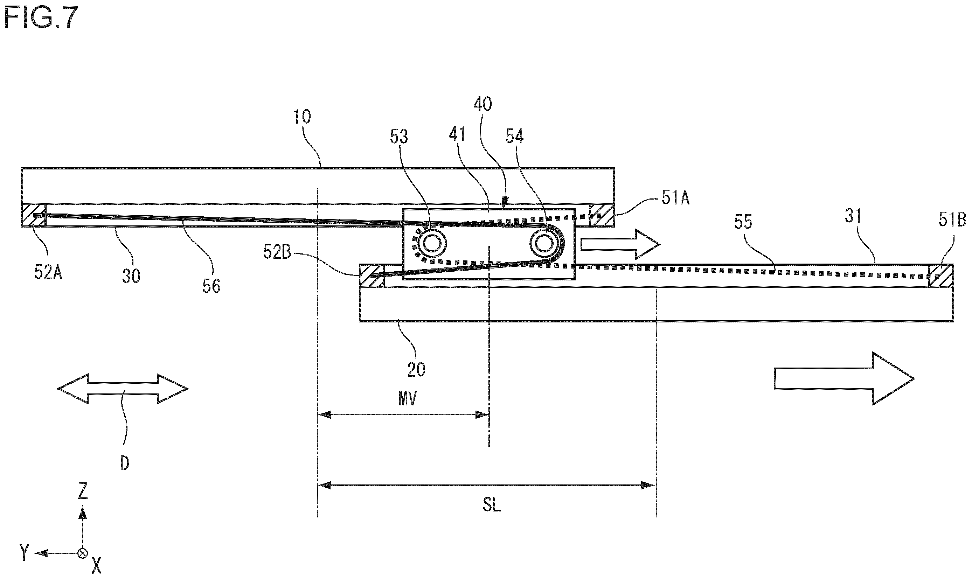

Next, a case where the lateral extender 8 laterally extends the slider 20 in the -Y direction will be described, with reference to Fig. 6 and Fig. 7. Fig. 6 and Fig. 7 are both diagrams for describing the lateral extension operation in the -Y direction performed by the lateral extender 8.

By driving a driver not shown in the drawings, the lateral extender 8 laterally extends the slider 20 in the - Y direction from the initial state shown in Fig. 2. As shown in Fig. 6, when the slider 20 is laterally extended in the -Y direction, the end of the right-side wrapping transmission member 55 that is fixed to the second right-side fixture 51B is pulled out in the -Y direction. The right-side wrapping transmission member 55 pushes the left-side guide member 53 in the -Y direction, causing it to move along with the coupler 42 while rotating. As the coupler 42 moves in the -Y direction, the two first linear guides 40, which are integrated with the coupler 42, move in the -Y direction. At this time, the movement amount of the first linear guide 40 relative to a lateral extension amount SL of the slider 20 in the -Y direction is a movement amount MV that is half of the lateral extension amount SL.

When the slider 20 is extended laterally in the -Y direction, the end of the left-side wrapping transmission member 56 fixed to the second left-side fixture 52B of the slider 20 moves in the -Y direction, however, the end fixed to the first left-side fixture 52A of the base 10 maintains its position. Therefore, the right-side guide member 54 moves in the -Y direction together with the first linear guide 40 while rotating. The first linear guide 40 is regulated from moving in the +Y direction by the right-side wrapping transmission member 55 being wrapped around the left-side guide member 53, and further, it is regulated from moving in the -Y direction by the left-side wrapping transmission member 56 being wrapped around the right-side guide member 54.

As shown in Fig. 7, even when the lateral extension amount SL of the slider 20 in the -Y direction reaches its maximum, the first linear guide 40 is still moved by the first transmission 50 in the -Y direction by the movement amount MV, which is half of the lateral extension amount SL. Thus, when the slider 20 is extended laterally in the -Y direction, the first linear guide 40 is moved in the -Y direction by the first transmission 50 by the movement amount MV, which is smaller than (half of) the lateral extension amount SL. The first linear guide 40 is regulated from moving in the Y direction (lateral extension direction D) by the right-side wrapping transmission member 55 being wrapped around the left-side guide member 53 and also the left-side wrapping transmission member 56 being wrapped around the right-side guide member 54. In other words, the first transmission 50 regulates the first linear guide 40 to a predetermined position in the -Y direction, in accordance with the lateral extension amount SL of the slider 20 in the -Y direction.

When returning the slider 20 from the state of being extended laterally in the -Y direction to the initial state shown in Fig. 2, the first transmission 50 regulates the return amount of the first linear guide 40 (the movement amount MV at the time) in accordance with the return amount of the slider 20 (the lateral extension amount SL at the time). At this time, the return amount of the first linear guide 40 is half of the return amount of the slider 20. As a result, when the slider 20 returns to the initial state shown in Fig. 2, the first linear guide 40 is positioned at the center or approximately the center of the base 10.

Thus, according to the first embodiment, the position of the first linear guide 40 is regulated when the slider 20 is not moving in the lateral extension direction D relative to the base 10, and the first linear guide 40 is moved in the lateral extension direction D when the slider 20 is moving in the lateral extension direction D relative to the base 10. With such a configuration, it is possible to regulate the movement amount MV of the first linear guide 40 in the lateral extension direction D in accordance with the lateral extension amount SL of the slider 20, while ensuring a long lateral extension amount SL of the slider 20. Moreover, when the slider 20 is not extended laterally, the first linear guide 40 is positioned at the center or approximately the center of the base 10, and thereby application of offset loads in the lateral extender 8 can be suppressed.

### Second Embodiment

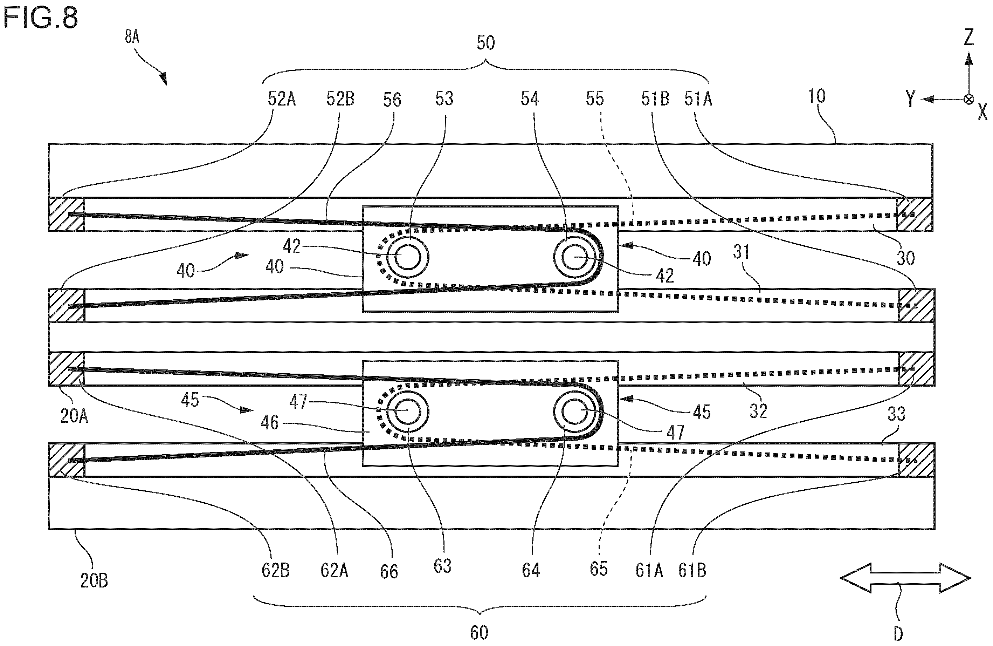

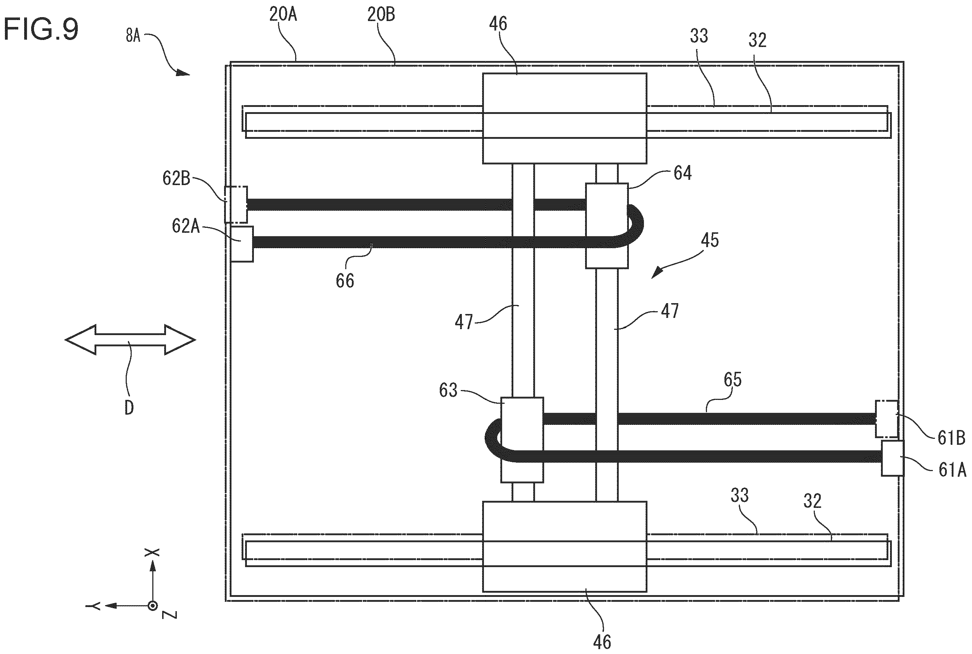

Hereunder, a lateral extender 8A according to a second embodiment will be described. Fig. 8 is a side view of the lateral extender 8A according to the second embodiment. Fig. 9 is a top view of a part of the lateral extender 8A according to the second embodiment. Fig. 9 shows a top view of a first slider 20A and a second slider 20B. In Fig. 9, the configurations similar to those in the above first embodiment are assigned with the same reference signs and the descriptions thereof are omitted or simplified. The lateral extender 8A according to the second embodiment is provided in the main body 4 of the overhead transport vehicle 1, as shown in Fig. 1.

As shown in Fig. 8, the lateral extender 8A includes a base 10, a first slider 20A, a second slider 20B, guide rails 30, 31, 32, 33, a first linear guide 40, a second linear guide 45, a first transmission 50, and a second transmission 60. By driving a driver not shown in the drawings, the lateral extender 8A laterally extends the first slider 20A in the lateral extension direction D relative to the base 10, and laterally extends the second slider 20B in the same lateral extension direction D relative to the first slider 20A, in conjunction with the lateral extension of the first slider 20A.

The first slider 20A is similar to the slider 20 of the first embodiment described above, and thus the description thereof will be omitted. In the second embodiment, the description from the first embodiment, where the slider 20 is replaced by the first slider 20A, is also applicable. The second slider 20B is arranged on the lower face side of the first slider 20A. The second slider 20B is, for example, a plate-shaped member, and is arranged so that its plane in the Z direction is parallel to the plane of the base 10 and the plane of the first slider 20A. The second slider 20B has, for example, the same shape as the first slider 20A. The transfer device 7 is provided on the lower face of the second slider 20B.

Similar to the first embodiment, the guide rail 31 is provided on the upper face of the first slider 20A. The guide rail 32 is provided on the lower face of the first slider 20A. The guide rail 32 is provided on the lower face of the first slider 20A, on both sides in the X direction. The guide rail 32 provided on the +X side of the lower face of the first slider 20A and the guide rail 32 provided on the -X side of the lower face of the first slider 20A are parallel to each other. The guide rail 32 is arranged so that its lengthwise direction is parallel to the traveling direction.

The guide rail 33 is provided on the upper face of the second slider 20B. The guide rail 33 is provided on the upper face of the second slider 20B, on both sides in the X direction. The guide rail 33 provided on the +X side of the upper face of the second slider 20B and the guide rail 33 provided on the -X side of the upper face of the second slider 20B are parallel to each other. The guide rail 33 is arranged so that its lengthwise direction is parallel to the traveling direction. The guide rail 32 on the +X side and the guide rail 33 on the +X side face each other in the Z direction. Also, the guide rail 32 on the - X side and the guide rail 33 on the -X side face each other in the Z direction.

Similar to the first embodiment, the first linear guide 40 is provided between the base 10 and the first slider 20A. The second linear guide 45 is provided between the first slider 20A and the second slider 20B. The first linear guide 40 is movable in the lateral extension direction D relative to the first slider 20A and the second slider 20B. The first linear guide 40 supports the second slider 20B so as to allow it to extend laterally relative to the first slider 20A. In other words, the second linear guide 45 allows the second slider 20B to move in the lateral direction D relative to the first slider 20A. The second linear guide 45 includes two blocks 46 and couplers 47.

The two blocks 46 are each arranged between the guide rail 32 and the guide rail 33. That is to say, the blocks 46 are each arranged between the guide rail 32 on the +X side and the guide rail 33 on the +X side, and between the guide rail 32 on the -X side and the guide rail 33 on the - X side. The blocks 46 are movable in the lateral extension direction D along the guide rails 32, 33 but is provided so as not to deviate in the Z direction. Therefore, the blocks 46 are suspended from the first slider 20A by the guide rails 32, and the second slider 20B is suspended from the blocks 46.

The couplers 47 connect the two blocks 46. Each coupler 47 extends in the X axis direction, with one end fixed to the block 46 provided on the +X side and the other end fixed to the block 46 provided on the -X side. In the example shown in Fig. 9, the two blocks 46 are connected to each other using the two couplers 47. However, the invention is not limited to this configuration, and two blocks 46 may be connected by one coupler 47. Moreover, the shape of the coupler 47 is not particularly limited, and may be a plate shape.

The second transmission 60 regulates the position of the second linear guide 45 in the lateral extension direction D relative to the first slider 20A. Specifically, the second transmission 60 regulates the position of the second linear guide 45 when the second slider 20B is not moving in the lateral extension direction D relative to the first slider 20A and moves the second linear guide 45 in the lateral extension direction D when the second slider 20B is moving in the lateral extension direction D relative to the first slider 20A. For example, the second transmission 60 moves the second linear guide 45 in the same direction as the first slider 20A, with a movement amount smaller than the lateral extension amount of the first slider 20A, in accordance with the lateral extension amount of the first slider 20A in the lateral extension direction D. In other words, the second linear guide 45 is movable in the lateral extension direction D, however, its movement is not unregulated and is regulated by the second transmission 60 to a movement amount according to the lateral extension amount.

The second transmission 60 regulates the second linear guide 45 to the center or approximately the center of the first slider 20A in the lateral extension direction D in the initial state where the second slider 20B is not extended laterally. When the second slider 20B is extended laterally from the initial state, the second transmission 60 moves the second linear guide 45 with a movement amount smaller than the lateral extension amount of the second slider 20B, relative to the direction in which the second slider 20B is extended laterally. When returning the second slider 20B to the initial state from the state of being extended laterally, the second transmission 60 returns the second linear guide 45 with a movement amount smaller than the return amount of the second slider 20B, relative to the return amount of the second slider 20B.

The second transmission 60 includes a third right-side fixture 61A, a fourth right-side fixture 61B, a third left-side fixture 62A, a fourth left-side fixture 62B, a second left-side guide member 63, a second right-side guide member 64, a second right-side wrapping transmission member 65, and a second left-side wrapping transmission member 66. In the second embodiment, the right-side wrapping transmission member 55 of the first embodiment is referred to as first right-side wrapping transmission member 55, and the left-side wrapping transmission member 56 of the first embodiment is referred to as first left-side wrapping transmission member 56. Also, in the second embodiment, the left-side guide member 53 of the first embodiment is referred to as first left-side guide member 53, and the right-side guide member 54 of the first embodiment is referred to as first right-side guide member 54.

The third right-side fixture 61A is provided on the right side of the first slider 20A in the lateral extension direction D. The third right-side fixture 61A is fixed to a region to the right side of the center of the first slider 20A in the lateral extension direction D. As an example, the third right-side fixture 61A is located on the -X side of the center of the first slider 20A and is fixed to a right-side end of or in the vicinity of the end of the first slider 20A.

The fourth right-side fixture 61B is provided on the right side of the upper face of the second slider 20B in the lateral extension direction D. The fourth right-side fixture 61B is fixed to a region to the right side of the center of the second slider 20B in the lateral extension direction D. As an example, the fourth right-side fixture 61B is located on the -X side of the center of the second slider 20B and is fixed to a right-side end of or in the vicinity of the end of the second slider 20B. The fourth right-side fixture 61B may be fixed at a position facing the third right-side fixture 61A in the Z direction. In other words, the fourth right-side fixture 61B and the third right-side fixture 61A may be fixed so as to be substantially overlapped when viewed from the Z direction. For the sake of description, in the illustration of Fig. 9, the third right-side fixture 61A and the fourth right-side fixture 61B are offset from each other in the X direction.

The third left-side fixture 62A is provided on the left side of the first slider 20A in the lateral extension direction D. The third left-side fixture 62A is fixed to a region to the left side of the center of the first slider 20A in the lateral extension direction D. As an example, the third left-side fixture 62A is located on the +X side of the center of the first slider 20A and is fixed to a left-side end of or in the vicinity of the end of the first slider 20A.

The fourth left-side fixture 62B is provided on the left side of the upper face of the second slider 20B in the lateral extension direction D. The fourth left-side fixture 62B is fixed to a region to the left side of the center of the second slider 20B in the lateral extension direction D. As an example, the fourth left-side fixture 62B is located on the +X side of the center of the second slider 20B and is fixed to a left-side end of or in the vicinity of the end of the second slider 20B. The fourth left-side fixture 62B may be fixed at a position facing the third left-side fixture 62A in the Z direction. In other words, the fourth left-side fixture 62B and the third left-side fixture 62A may be fixed so as to be substantially overlapped when viewed from the Z direction. For the sake of description, in the illustration of Fig. 9, the third left-side fixture 62A and the fourth left-side fixture 62B are offset from each other in the X direction.

The second left-side guide member 63 is provided on the coupler 47. The second left-side guide member 63 is provided on the left side in the lateral extension direction D of the second linear guide 45. In the example shown in Fig. 9, the second left-side guide member 63 is provided on the left-side coupler 47 of the two couplers 42. The second left-side guide member 63 is provided on the -X side of the coupler 47. When viewed from the Z direction, the second left-side guide member 63 is arranged on a straight line passing through the third right-side fixture 61A and the fourth right-side fixture 61B in the Y direction. For example, the face of the second left-side guide member 63 that is in contact with the second right-side wrapping transmission member 65 is a curved face. The second left-side guide member 63 is, for example, a pulley or a roller.

The second right-side guide member 64 is provided on the coupler 47. The second right-side guide member 64 is provided on the right side in the lateral extension direction D of the second linear guide 45. In the example shown in Fig. 9, the second right-side guide member 64 is provided on the right-side coupler 47 of the two couplers 47. The second right-side guide member 64 is provided on the +X side of the coupler 47. When viewed from the Z direction, the second right-side guide member 64 is arranged on a straight line passing through the third left-side fixture 62A and the fourth left-side fixture 62B in the Y direction. For example, the face of the second right-side guide member 64 that is in contact with the second left-side wrapping transmission member 66 is a curved face. The second right-side guide member 64 is, for example, a pulley or a roller.

The second right-side wrapping transmission member 65 has one end fixed to the third right-side fixture 61A of the first slider 20A. The second right-side wrapping transmission member 65 is wrapped around the second left-side guide member 63 and has the other end fixed to the fourth right-side fixture 61B of the second slider 20B. The second right-side wrapping transmission member 65 applies a force to the second linear guide 45, which supports the second left-side guide member 63, toward the right side of the lateral extension direction D, that is, in the -Y direction. The second right-side wrapping transmission member 65 is, for example, a belt or a wire. The second right-side wrapping transmission member 65 may be an elastic member in the form of a belt or string.

The second left-side wrapping transmission member 66 has one end fixed to the third left-side fixture 62A of the first slider 20A. The second left-side wrapping transmission member 66 is wrapped around the second right-side guide member 64 and has the other end fixed to the fourth left-side fixture 62B of the second slider 20B. The second left-side wrapping transmission member 66 applies a force to the second linear guide 45, on which the second right-side guide member 64 is fixed, toward the left side of the lateral extension direction D, that is, in the +Y direction. The second left-side wrapping transmission member 66 is, for example, a belt or a wire. The second left-side wrapping transmission member 66 may be an elastic member in the form of a belt or string. For example, the second right-side wrapping transmission member 65 and the second left-side wrapping transmission member 66 are set to have a same or approximately same length.

As shown in Fig. 8 and Fig. 9, the second linear guide 45 is regulated from moving in the -Y direction by the second left-side wrapping transmission member 66 being wrapped around the second right-side guide member 64, and further, it is regulated from moving in the +Y direction by the second right-side wrapping transmission member 65 being wrapped around the second left-side guide member 63. Therefore, in the initial state, the position of the second linear guide 45 is regulated to the center or approximately the center of the base 10 (first slider 20A and second slider 20B) in the Y direction (lateral extension direction D) and the movement of the second linear guide 45 is not unregulated in the Y direction. Therefore, the second linear guide 45 is prevented from being arranged offset in the Y direction. As described above, in the initial state, the position of the first linear guide 40 is regulated to the center or approximately the center of the base 10 in the Y direction.

As a result, even when the holder 7A is holding an article F, a load is applied from the second slider 20B to the center portion of the first slider 20A via the second linear guide 45, and a load is applied from the first slider 20A to the center portion of the base 10 via the first linear guide 40. Thus, the main body 4 suspended from the traveler 2 is prevented from tilting, and the overhead transport vehicle 1 can stably travel.

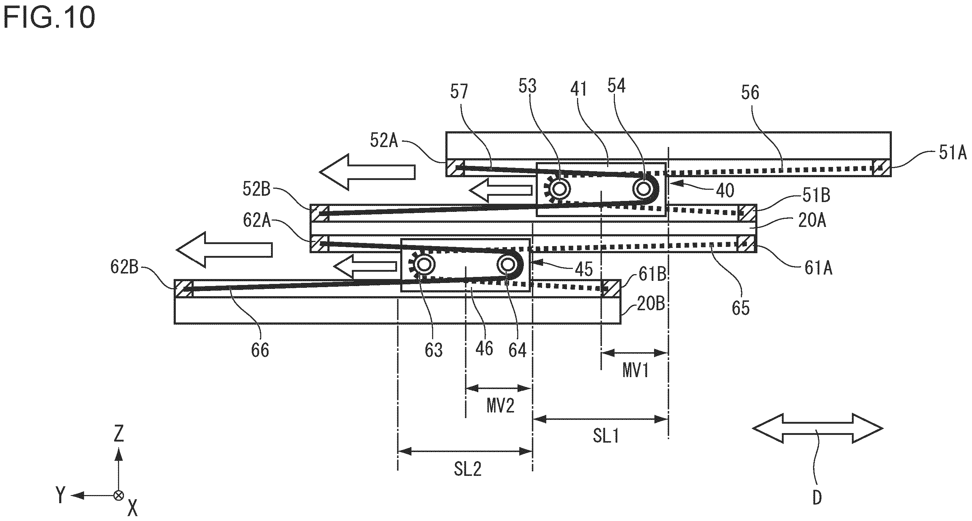

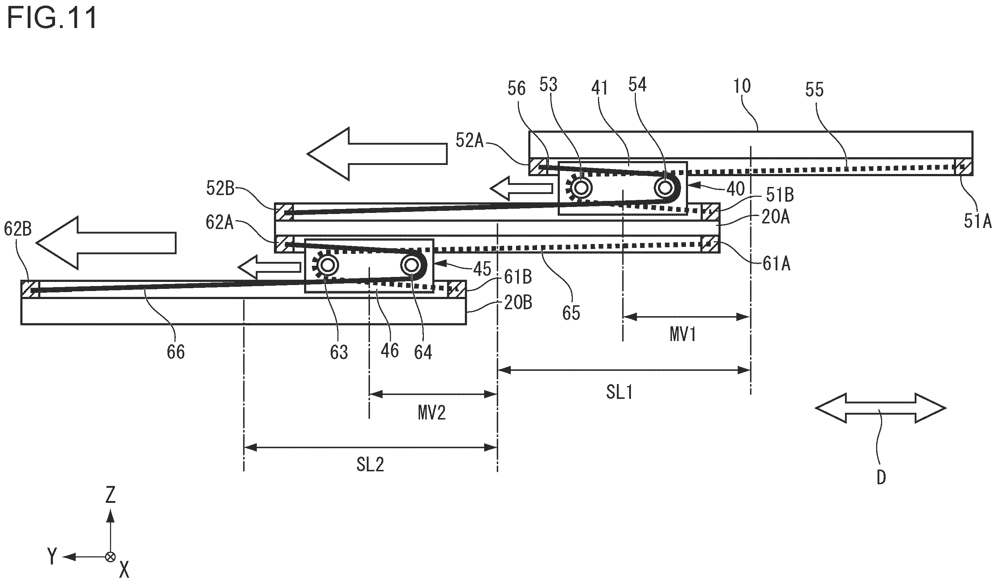

Next, the operation of the lateral extender 8A will be described. A case where the lateral extender 8A laterally extends the first slider 20A and the second slider 20B in the +Y direction will be described, with reference to Fig. 10 and Fig. 11. Fig. 10 and Fig. 11 are both diagrams for describing the lateral extension operation in the +Y direction performed by the lateral extender 8A.

By driving a driver not shown in the drawings, the lateral extender 8A laterally extends the first slider 20A and the second slider 20B in the +Y direction from the initial state shown in Fig. 8. When the first slider 20A and the second slider 20B are extended laterally in the +Y direction, the first slider 20A moves in the +Y direction relative to the base 10, and the second slider 20B moves in the +Y direction relative to the first slider 20A in conjunction with the lateral extension of the first slider 20A. As shown in Fig. 10, when the first slider 20A is laterally extended in the +Y direction, as in the first embodiment described above, the end of the first left-side wrapping transmission member 56 that is fixed to the second left-side fixture 52B is pulled out in the +Y direction and the first linear guide 40 moves in the +Y direction together with the first right-side guide member 54. At this time, the movement amount of the first linear guide 40 relative to a lateral extension amount SL1 of the first slider 20A in the +Y direction is a movement amount MV1 that is half of the lateral extension amount SL1. As in the first embodiment, the position of the first linear guide 40 is generally regulated by the lateral extension amount SL1 of the first slider 20A.

When the second slider 20B is laterally extended in the +Y direction, the end of the second left-side wrapping transmission member 66 that is fixed to the fourth left-side fixture 62B is pulled out in the +Y direction. The second left-side wrapping transmission member 66 pushes the second right-side guide member 64 in the +Y direction, causing it to move along with the coupler 47 while rotating. As the coupler 47 moves in the +Y direction, the two blocks 46 (second linear guide 45), which are integrated with the coupler 47, move in the +Y direction. At this time, the movement amount of the second linear guide 45 relative to a lateral extension amount SL2 of the second slider 20B in the +Y direction is a movement amount MV2 that is half of the lateral extension amount SL2.

When the second slider 20B is extended laterally in the +Y direction, the end of the second right-side wrapping transmission member 65 fixed to the fourth right-side fixture 61B of the second slider 20B moves in the +Y direction, however, the end fixed to the third right-side fixture 61A of the first slider 20A maintains its position. Therefore, the second left-side guide member 63 moves in the +Y direction together with the second linear guide 45 while rotating. The second linear guide 45 is regulated from moving in the -Y direction by the second left-side wrapping transmission member 66 being wrapped around the second right-side guide member 64, and further, it is regulated from moving in the +Y direction by the second right-side wrapping transmission member 65 being wrapped around the second left-side guide member 63.

As shown in Fig. 11, even when the lateral extension amount SL1 of the first slider 20A in the +Y direction reaches its maximum, the first linear guide 40 is still moved by the first transmission 50 in the +Y direction by the movement amount MV, which is half of the lateral extension amount SL, and as in the first embodiment, it moves in the +Y direction by the movement amount MV1, which is smaller than (half of) the lateral extension amount SL1 of the first slider 20A. As in the first embodiment, the position of the first linear guide 40 is regulated in accordance with the lateral extension amount SL1 of the first slider 20A in the +Y direction.

Even when the lateral extension amount SL2 of the second slider 20B in the +Y direction reaches its maximum, the second linear guide 45 is still moved by the second transmission 60 in the +Y direction by the movement amount MV2, which is half of the lateral extension amount SL2. Thus, when the second slider 20B is extended laterally in the +Y direction, the second linear guide 45 is moved in the +Y direction by the second transmission 60 by the movement amount MV2, which is smaller than (half of) the lateral extension amount SL2. The second linear guide 45 is regulated from moving in the Y direction (lateral extension direction D) by the second left-side wrapping transmission member 66 being wrapped around the second right-side guide member 64 and also the second right-side wrapping transmission member 65 being wrapped around the second left-side guide member 63. In other words, the second transmission 60 regulates the second linear guide 45 to a predetermined position in the +Y direction, in accordance with the lateral extension amount SL of the second slider 20B in the +Y direction.

Thus, the lateral extender 8A laterally extends the first slider 20A and the second slider 20B, thereby enabling the holder 7A provided on the lower face of the second slider 20B to be extended laterally in the +Y direction relative to the main body 4 by an amount equal to the sum of the lateral extension amount SL1 and the lateral extension amount SL2.

When returning the first slider 20A and the second slider 20B from the state of being extended laterally in the +Y direction to the initial state shown in Fig. 8, the first transmission 50 regulates the return amount of the first linear guide 40 (the movement amount MV1 at the time) in accordance with the return amount of the first slider 20A (the lateral extension amount SL1 at the time). Meanwhile, the second transmission 60 regulates the return amount of the second linear guide 45 (the movement amount MV2 at the time) in accordance with the return amount of the second slider 20B (the lateral extension amount SL2 at the time). At this time, the return amount of the first linear guide 40 is half of the return amount of the first slider 20A, and the return amount of the second linear guide 45 is half of the return amount of the second slider 20B. As a result, when the first slider 20A and the second slider 20B return to the initial state shown in Fig. 8, the first linear guide 40 and the second linear guide 45 are both positioned at the center or approximately the center of the base 10.

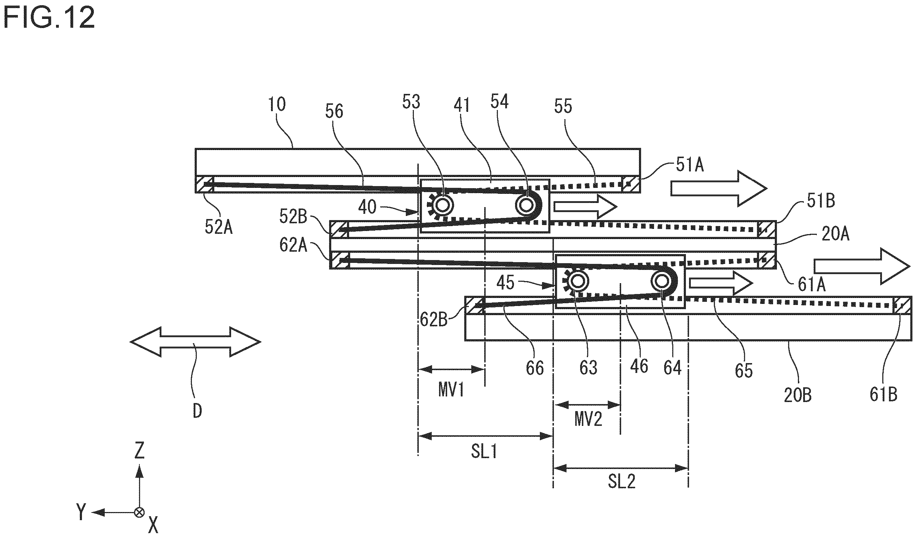

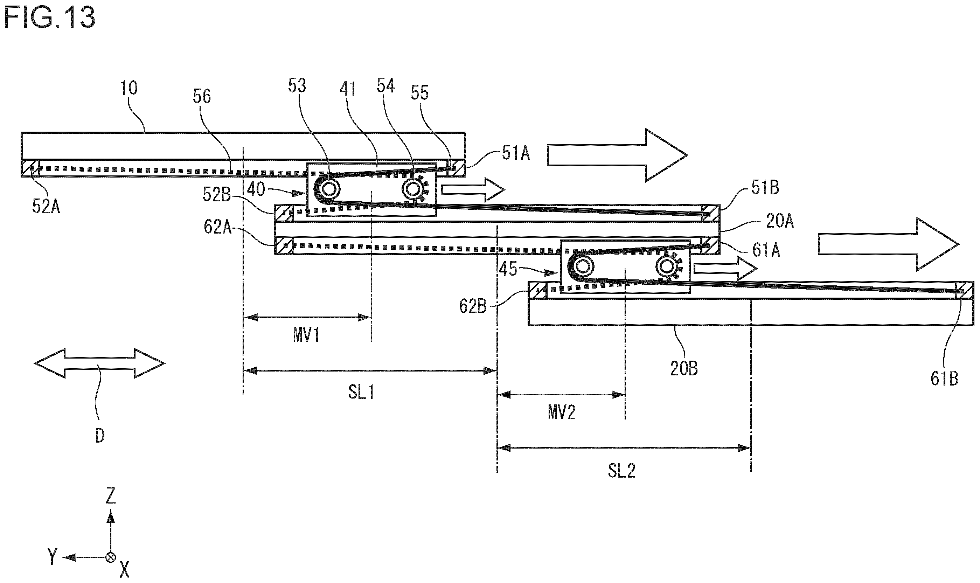

Next, a case where the lateral extender 8A laterally extends the first slider 20A and the second slider 20B in the -Y direction will be described, with reference to Fig. 12 and Fig. 13. Fig. 12 and Fig. 13 are both diagrams for describing the lateral extension operation in the -Y direction performed by the lateral extender 8A.

By driving a driver not shown in the drawings, the lateral extender 8A laterally extends the first slider 20A and the second slider 20B in the -Y direction from the initial state shown in Fig. 8. When the first slider 20A and the second slider 20B are extended laterally in the -Y direction, the first slider 20A moves in the -Y direction relative to the base 10, and the second slider 20B moves in the -Y direction relative to the first slider 20A, in conjunction with the lateral extension of the first slider 20A. As shown in Fig. 12, when the first slider 20A is laterally extended in the -Y direction, as in the first embodiment described above, the end of the first right-side wrapping transmission member 55 that is fixed to the second right-side fixture 51B is pulled out in the -Y direction and the first linear guide 40 moves in the -Y direction together with the first left-side guide member 53. At this time, the movement amount of the first linear guide 40 relative to a lateral extension amount SL1 of the first slider 20A in the -Y direction is a movement amount MV1 that is half of the lateral extension amount SL1. As in the first embodiment, the position of the first linear guide 40 is generally regulated by the lateral extension amount SL1 of the first slider 20A.

When the second slider 20B is laterally extended in the -Y direction, the end of the second right-side wrapping transmission member 65 that is fixed to the fourth right-side fixture 61B is pulled out in the -Y direction. The second right-side wrapping transmission member 65 pushes the second left-side guide member 63 in the -Y direction, causing it to move along with the coupler 47 while rotating. As the coupler 47 moves in the -Y direction, the two blocks 46 (second linear guide 45), which are integrated with the coupler 47, move in the -Y direction. At this time, the movement amount of the second linear guide 45 relative to a lateral extension amount SL2 of the second slider 20B in the -Y direction is a movement amount MV2 that is half of the lateral extension amount SL2.

When the second slider 20B is extended laterally in the -Y direction, the end of the second left-side wrapping transmission member 66 fixed to the fourth left-side fixture 62B of the second slider 20B moves in the -Y direction, however, the end fixed to the third left-side fixture 62A of the first slider 20A maintains its position. Therefore, the second right-side guide member 64 moves in the -Y direction together with the second linear guide 45 while rotating. The second linear guide 45 is regulated from moving in the +Y direction by the second right-side wrapping transmission member 65 being wrapped around the second left-side guide member 63, and further, it is regulated from moving in the -Y direction by the second left-side wrapping transmission member 66 being wrapped around the second right-side guide member 64.

As shown in Fig. 13, even when the lateral extension amount SL1 of the first slider 20A in the +Y direction reaches its maximum, the first linear guide 40 is still moved by the first transmission 50 in the -Y direction by the movement amount MV, which is half of the lateral extension amount SL1, and as in the first embodiment, it moves in the -Y direction by the movement amount MV1, which is smaller than (half of) the lateral extension amount SL1 of the first slider 20A. As in the first embodiment, the position of the first linear guide 40 is regulated in accordance with the lateral extension amount SL1 of the first slider 20A in the -Y direction.

Even when the lateral extension amount SL2 of the second slider 20B in the -Y direction reaches its maximum, the second linear guide 45 is still moved by the second transmission 60 in the -Y direction by the movement amount MV2, which is half of the lateral extension amount SL2. Thus, when the second slider 20B is extended laterally in the -Y direction, the second linear guide 45 is moved in the -Y direction by the second transmission 60 by the movement amount MV2, which is smaller than (half of) the lateral extension amount SL2. The second linear guide 45 is regulated from moving in the Y direction (lateral extension direction D) by the second right-side wrapping transmission member 65 being wrapped around the second left-side guide member 63 and also the second left-side wrapping transmission member 66 being wrapped around the second right-side guide member 64. In other words, the second transmission 60 regulates the second linear guide 45 to a predetermined position in the -Y direction, in accordance with the lateral extension amount SL of the second slider 20B in the -Y direction.

Thus, the lateral extender 8A laterally extends the first slider 20A and the second slider 20B, thereby enabling the holder 7A provided on the lower face of the second slider 20B to be extended laterally in the -Y direction relative to the main body 4 by an amount equal to the sum of the lateral extension amount SL1 and the lateral extension amount SL2.

When returning the first slider 20A and the second slider 20B from the state of being extended laterally in the -Y direction to the initial state shown in Fig. 8, as described above, the lateral extender 8A regulates the return amount of both the first linear guide 40 and the second linear guide 45 (the movement amounts MV1, MV2 at the time) in accordance with the return amount of both the first slider 20A and the second slider 20B (the lateral extension amounts SL1, SL2 at the time). At this time, the return amount of the first linear guide 40 is half of the return amount of the first slider 20A, and the return amount of the second linear guide 45 is half of the return amount of the second slider 20B. As a result, when the first slider 20A and the second slider 20B return to the initial state shown in Fig. 8, the first linear guide 40 and the second linear guide 45 are both positioned at the center or approximately the center of the base 10.

Thus, according to the second embodiment, even in the case where the lateral extender 8A is of a three-stage configuration consisting of the base 10, the first slider 20A, and the second slider 20B, as in the first embodiment, it is possible to regulate the movement amounts MV1, MV2 of the first linear guide 40 and the second linear guide 45 in the lateral extension direction D in accordance with the lateral extension amounts SL1, SL2 of the first slider 20A and the second slider 20B, while ensuring long lateral extension amounts SL1, SL2 of the first slider 20A and the second slider 20B. Moreover, when the first slider 20A and the second slider 20B are not extended laterally, the first linear guide 40 and the second linear guide 45 are positioned at the center or approximately the center of the base 10, and thus, application of offset loads in the lateral extender 8A can be suppressed.

### Modified Example

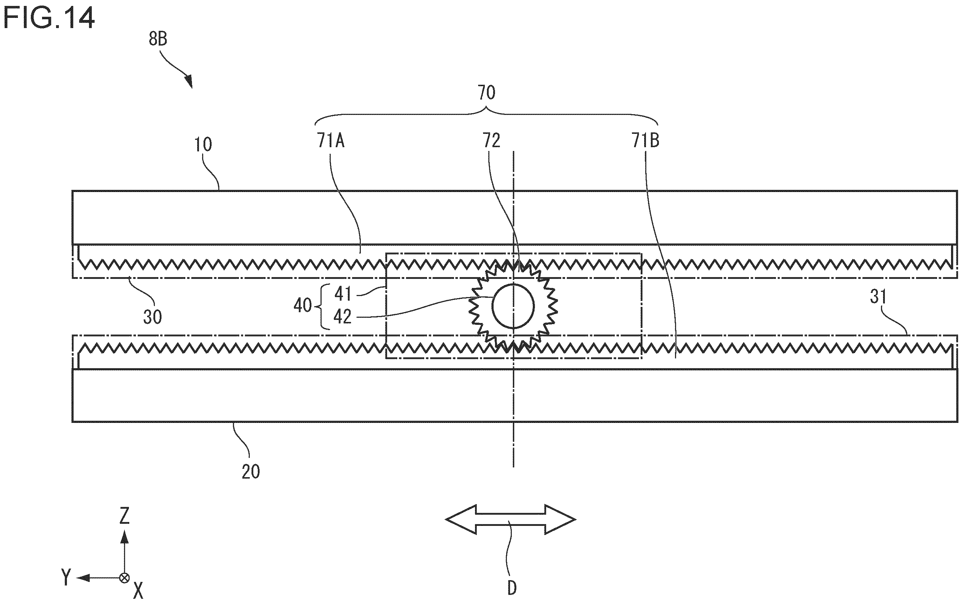

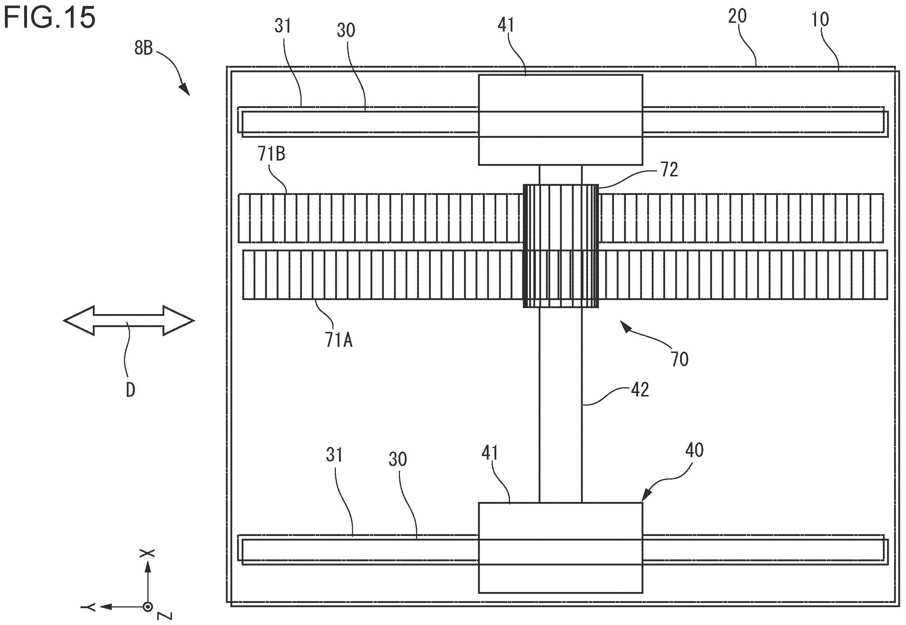

Next, a first transmission 70 according to a modified example will be described. Fig. 14 is a diagram of the first transmission 70 according to the modified example, as viewed from the X direction. Fig. 15 is a diagram of the first transmission 70 according to the modified example, as viewed from the Z direction. The first transmission 70 can be applied in place of the first transmission 50 in both the first embodiment and the second embodiment. Also, the first transmission 70 may be applied in place of the second transmission 60 in the second embodiment. In the following description of the present modified example, the same configurations as those of the first embodiment described above are assigned with the same reference signs and the descriptions thereof are omitted or simplified.

The first transmission 70 regulates the position of the first linear guide 40 in the lateral extension direction D relative to the base 10. The first transmission 70 moves the first linear guide 40 in the same direction as the slider 20, with a movement amount smaller than the lateral extension amount of the slider 20, in accordance with the lateral extension amount of the slider 20 in the lateral extension direction D. That is to say, the first linear guide 40 is movable in the lateral extension direction D. However, the movement of the first linear guide 40 is not unregulated and is regulated by the movement amount according to the lateral extension amount of the slider 20. The first transmission 70 regulates the first linear guide 40 to the center or approximately the center of the base 10 in the lateral extension direction D in the initial state where the slider 20 is not extended laterally (where the lateral extension amount is zero or approximately zero).

When the slider 20 is extended laterally from the initial state, the first transmission 70 moves the first linear guide 40 with a movement amount smaller than the lateral extension amount of the slider 20, relative to the direction in which the slider 20 is extended laterally. When returning the slider 20 to the initial state from the state of being extended laterally, the first transmission 70 returns the first linear guide 40 with a movement amount smaller than the return amount of the slider 20.

As shown in Fig. 14 and Fig. 15, the first transmission 70 includes a pair of rack gears 71A, 71B and a pinion gear 72. The rack gear 71A is provided on the lower face of the base 10 and is arranged along the Y direction (lateral extension direction D). The rack gear 71B is provided on the upper face of the slider 20 and is arranged along the Y direction (lateral extension direction D). The rack gear 71A and the rack gear 71B face each other in the Z direction. For the sake of description, in the illustration of Fig. 15, the rack gear 71A and the rack gear 71B are offset from each other in the X direction. The pinion gear 72 is provided so as to be able to rotate relative to the coupler 42. The pinion gear 72 is arranged between the rack gear 71A and the rack gear 71B. The pinion gear 72 meshes with both the rack gear 71A and the rack gear 71B.

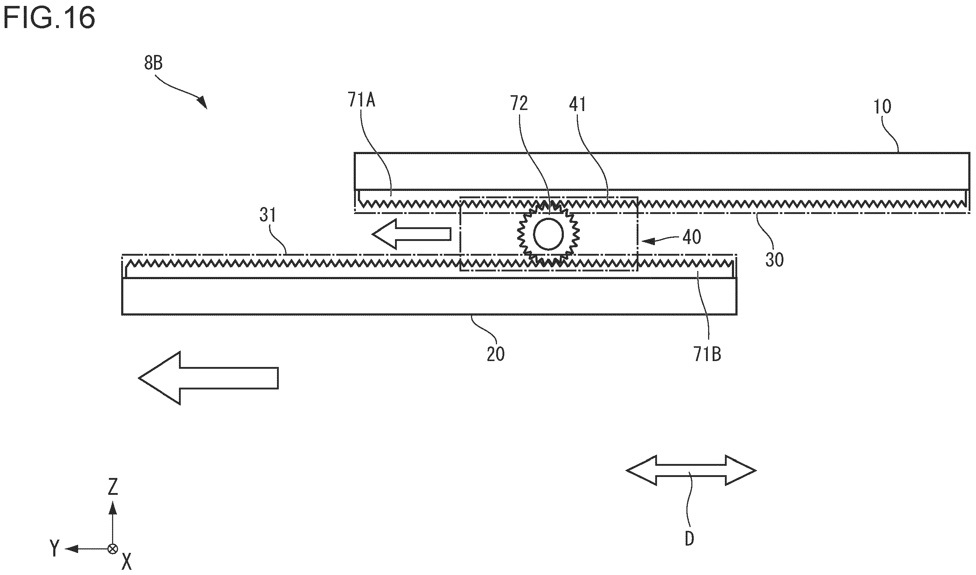

Next, the operation of a lateral extender 8B will be described. Hereunder, a case where the lateral extender 8B laterally extends the slider 20 in the +Y direction will be described. Fig. 16 is a diagram for describing the lateral extension operation in the Y direction performed by the lateral extender 8B to which the first transmission 70 is applied. By driving a driver not shown in the drawings, the lateral extender 8B moves the slider 20 relative to the base 10 in the +Y direction. The movement of the slider 20 in the +Y direction causes the rack gear 71B to move in the +Y direction. The movement of the rack gear 71B in the Y direction causes the pinion gear 72, which meshes with the rack gear 71B, to rotate.

When the pinion gear 72 rotates, the pinion gear 72 moves in the +Y direction along with the coupler 42 due to engagement of the pinion gear 72 with the rack gear 71A. Therefore, the two blocks 41 (first linear guide 40), which are integrated with the coupler 42, move in the +Y direction. At this time, the movement amount of the first linear guide 40 is smaller than the movement amount of the slider 20. For example, the movement amount of the first linear guide 40 is half of the return amount of the slider 20. Moreover, since the pinion gear 72 engages with both the rack gears 71A, 71B, the first linear guide 40 is prevented from moving freely in the lateral extension direction D, resulting in its position being regulated. In other words, the first transmission 70 regulates the first linear guide 40 to a predetermined position in the +Y direction, in accordance with the lateral extension amount SL of the slider 20 in the +Y direction.

When returning the slider 20 from the state of being extended laterally in the +Y direction to the initial state shown in Fig. 14, the first transmission 70 regulates the return amount of the first linear guide 40 in accordance with the return amount of the slider 20. At this time, the return amount of the first linear guide 40 is half of the return amount of the slider 20. As a result, when the slider 20 returns to the initial state shown in Fig. 14, the first linear guide 40 is positioned at the center or approximately the center of the base 10. It should be noted that the same explanation also applies when laterally extending the slider 20 in the -Y direction.

Thus, in the modified example also, the position of the first linear guide 40 in the lateral extension direction D relative to the base 10 is regulated, and the first linear guide 40 is moved in the same direction as the slider 20, with a movement amount smaller than the lateral extension amount SL of the slider 20, in accordance with the lateral extension amount of the slider 20 in the lateral extension direction D. Therefore, it is possible to regulate the movement amount MV of the first linear guide 40 in the lateral extension direction D in accordance with the lateral extension amount SL of the slider 20, while ensuring a long lateral extension amount SL of the slider 20. Moreover, when the slider 20 is not extended laterally, the first linear guide 40 is positioned at the center or approximately the center of the base 10, and thereby application of offset loads in the lateral extender 8 can be suppressed.

Furthermore, the pinion gear 72 may also be driven to rotate by an electric motor or other similar means. In such a case, the pinion gear 72 and the rack gears 71A, 71B function as a driver for laterally extending the slider 20 in the lateral extender 8B. In other words, the first transmission 70 is used as a driver to laterally extend the slider 20 and is also used as a configuration to regulate the movement of the first linear guide 40.

The embodiments and the modified example have been described above. However, the technical scope of the invention is not limited to the embodiments and the modified example described above. It is also apparent to those skilled in the art that various modifications or improvements can be added to the above embodiments and modified example. It is also apparent from the scope of claims that the present invention also encompasses one or more of such modifications or improvements. One or more of the requirements described in the above embodiments and modified example may be omitted in some cases. One or more of the requirements described in the above embodiments and modified example may be combined where appropriate. The order of executing procedures shown in the embodiments can be implemented in an arbitrary order unless the result of the previous procedure is used in the following procedure. While operations in the above embodiment have been described with expressions such as "first", "next", and "subsequently" for the sake of convenience, the operations need not always be implemented in that order. The contents of Japanese Patent Application No. 2022-089789 and all documents cited in the detailed description of the present invention are incorporated herein by reference to the extent permitted by law.

### Description of Reference Signs

1: Overhead transport vehicle
2: Traveler
3: Coupler
4: Main body
6: Transferer
7: Transfer device
8, 8A, 8B: Lateral extender
10: Base
20: Slider
30, 31, 32, 33: Guide rail
40: First linear guide
45: Second linear guide
50, 70: First transmission
51A: First right-side fixture
51B: Second right-side fixture
52A: First left-side fixture
52B: Second left-side fixture
53: Left-side guide member (first left-side guide member)
54: Right-side guide member (first right-side guide member)
55: Right-side wrapping transmission member (first right-side wrapping transmission member)
56: Left-side wrapping transmission member (first left-side wrapping transmission member)
60: Second transmission
61A: Third right-side fixture
61B: Fourth right-side fixture
62A, 62B: Left-side fixture
63: Second left-side guide member
64: Second right-side guide member
65: Second right-side wrapping transmission member
66: Second left-side wrapping transmission member
D: Lateral extension direction

## Claims

1. An overhead transport vehicle comprising:
a main body that travels along an overhead track; and
a lateral extender that laterally extends a transfer device for an article in a left-right direction relative to a traveling direction of the main body,
wherein the lateral extender includes
a base provided on the main body,
a slider provided with the transfer device and arranged on a lower face side of the base,
a first linear guide that is provided between the base and the slider, is movable in a lateral direction relative to the base and the slider, and supports the slider so as to allow it to extend laterally relative to the base, and
a first transmission that regulates a position of the first linear guide when the slider is not moving in the lateral extension direction relative to the base, and that moves the first linear guide in the lateral extension direction when the slider is moving in the lateral extension direction relative to the base.

2. The overhead transport vehicle according to claim 1,
wherein the first transmission regulates the first linear guide to a center or approximately a center of the base in the lateral extension direction in an initial state in which the slider is not extended laterally.

3. The overhead transport vehicle according to claim 2,
wherein when laterally extending the slider from the initial state, the first transmission moves the first linear guide in a same direction as a direction in which the slider is extended laterally, with a movement amount equal to half of a lateral extension amount of the slider.

4. The overhead transport vehicle according to claim 1,
wherein the first transmission includes
a right-side wrapping transmission member, one end of which is fixed to a first right-side fixture provided on a right side of the base in the lateral extension direction and wrapped around a left-side guide member provided on a left side of the first linear guide in the lateral extension direction, while another end of which is fixed to a second right-side fixture provided on a right side of the slider in the lateral extension direction, and
a left-side wrapping transmission member, one end of which is fixed to a first left-side fixture provided on a left side of the base in the lateral extension direction and wrapped around a right-side guide member provided on a right side of the first linear guide in the lateral extension direction, while another end of which is fixed to a second left-side fixture provided on a left side of the slider in the lateral extension direction.

5. The overhead transport vehicle according to claim 4,
wherein the right-side wrapping transmission member and the left-side wrapping transmission member are set to have a same or approximately same length.

6. The overhead transport vehicle according to claim 1,
wherein the slider includes
a first slider arranged on the lower face side of the base, and
a second slider provided with the transfer device and arranged on a lower face side of the first slider, and
wherein including
a second linear guide that is provided between the first slider and the second slider, is movable in a lateral direction relative to the first slider and the second slider, and supports the second slider so as to allow it to extend laterally relative to the first slider, and
a second transmission that regulates a position of the second linear guide when the second slider is not moving in the lateral extension direction relative to the first slider, and that moves the second linear guide in the lateral extension direction when the second slider is moving in the lateral extension direction relative to the first slider.

7. The overhead transport vehicle according to claim 6,
wherein the first transmission regulates the first linear guide to a center or approximately a center of the base in the lateral extension direction in an initial state in which the first slider and the second slider are not extended laterally, and
wherein the second transmission regulates the second linear guide to a center or approximately a center of the first slider in the lateral extension direction in the initial state.

8. The overhead transport vehicle according to claim 7,
wherein when laterally extending the first slider from the initial state, the first transmission moves the first linear guide in a same direction as a direction in which the first slider is extended laterally, with a movement amount equal to half of a lateral extension amount of the first slider, and
wherein when laterally extending the second slider from the initial state, the second transmission moves the second linear guide in a same direction as a direction in which the second slider is extended laterally, with a movement amount equal to half of a lateral extension amount of the second slider.

9. The overhead transport vehicle according to claim 6,
wherein the first transmission includes
a first right-side wrapping transmission member, one end of which is fixed to a first right-side fixture provided on a right side of the base in the lateral extension direction and wrapped around a first left-side guide member provided on a left side of the first linear guide in the lateral extension direction, while another end of which is fixed to a second right-side fixture provided on a right side of the first slider in the lateral extension direction, and
a first left-side wrapping transmission member, one end of which is fixed to a first left-side fixture provided on a left side of the base in the lateral extension direction and wrapped around a first right-side guide member provided on a right side of the first linear guide in the lateral extension direction, while another end of which is fixed to a second left-side fixture provided on a left side of the first slider in the lateral extension direction, and
wherein the second transmission includes
a second right-side wrapping transmission member, one end of which is fixed to a third right-side fixture provided on a right side of the first slider in the lateral extension direction and wrapped around a second left-side guide member provided on a left side of the second linear guide in the lateral extension direction, while another end of which is fixed to a fourth right-side fixture provided on a right side of the second slider in the lateral extension direction, and
a second left-side wrapping transmission member, one end of which is fixed to a third left-side fixture provided on a left side of the first slider in the lateral extension direction and wrapped around a second right-side guide member provided on a right side of the second linear guide in the lateral extension direction, while another end of which is fixed to a fourth left-side fixture provided on a left side of the second slider in the lateral extension direction.

10. The overhead transport vehicle according to claim 9,
wherein the first right-side wrapping transmission member and the first left-side wrapping transmission member are set to have a same or approximately same length, and
wherein the second right-side wrapping transmission member and the second left-side wrapping transmission member are set to have a same or approximately same length.
